# EUROPEAN PATENT APPLICATION

(11) **EP 1 341 215 A1**
(43) Date of publication of application: **03.09.2003**
(21) Application number: 01998990.4
(22) Date of filing: 29.11.2001
(51) Int. Cl.: H01L 21/02, H05B 3/68, H01B 3/16, H05B 3/10, H05B 3/20

(54) **CERAMIC HEATER FOR SEMICONDUCTOR MANUFACTURING AND INSPECTING DEVICES**

(30) Priority: 29.11.2000 JP 2000363668
(71) Applicant: IBIDEN CO., LTD., Ogaki-shi Gifu-ken 503-0917 (JP)
(72) Inventor: KARIYA, Satoru, Ibi-gun, gifu 501-0695 (JP); ITO, Yasutaka, Ibi-gun, gifu 501-0695 (JP)
(74) Representative: Gillard, Marie-Louise
(86) International application number: JP0110441
(87) International publication number: WO02045138

(57) **Abstract**

An object of the present invention is to provide a ceramic heater for a semiconductor-producing/examining device which has a short temperature dropping time and can be rapidly cooled. The present invention is a ceramic heater for a semiconductor-producing/examining device comprising a resistance heating element on a surface thereof, wherein the resistance heating element has a surface roughness Ra according to JIS B 0601 of 0.01 µm or more.

## Description

### Technical Field

The present invention relates to a ceramic heater used for drying, sputtering and the like mainly in the semiconductor industry, and a ceramic heater for a semiconductor-producing/examining device which can be used as an electrostatic chuck, a chuck top plate for a wafer prober, and the like.

### Background Art

A semiconductor product is a very important product which is necessary in various industries. A semiconductor chip, which is a typical product thereof, is produced, for example, by slicing a silicon monocrystal into a predetermined thickness to produce a silicon wafer and subsequently forming various circuits and the like on this silicon wafer.

In order to produce a circuit and the like of such a type, necessary is the step of applying a photosensitive resin onto a silicon wafer, subjecting this to light exposure and developing treatment, subjecting the resultant to post-curing, and then forming a conductor layer by sputtering. For this purpose, it is necessary to heat the silicon wafer.

Hitherto, as a heater for heating such a silicon wafer, there has been frequently used a heater having a resistance heating element such as an electrical resistor on the back side of a substrate made of aluminum. Since the substrate made of aluminum requires a thickness of about 15 mm, the substrate is large in weight and bulky. Thus, the substrate is not easy to handle. Moreover, the temperature-controllability is insufficient from the viewpoint of temperature-following character in relation to a passing electric current. Thus, it was not easy to heat the silicon wafer uniformly.

Thus, in recent years, ceramic heaters using a ceramic such as aluminum nitride as a substrate have been developed. Since these ceramic heaters are superior in mechanical properties such as bending strength, the thickness thereof can be reduced. Additionally, the heat capacity thereof can be made small; therefore, various properties such as temperature-following character are superior.

### Summary of the Invention

However, in recent production of semiconductor products, it has been demanded to shorten a time necessary for throughput, and it has been strongly demanded to shorten not only a temperature-raising time but particularly a cooling time. Thus, ceramic heaters capable of rapid temperature drop have been demanded.

However, there remains a problem that it is difficult to lower the temperature of conventional ceramic heaters rapidly.

By forming an insulating covering layer on the surface of a resistance heating element, it is possible to suppress a change in the resistance value thereof, which results from oxidation and/or sulfurization of the resistance heating element by oxygen or SOₓ in the air. However, there may arise a problem that cracks are generated in the insulating covering layer by raising and lowering the temperature of the ceramic heater repeatedly (a heat cycle).

The inventors made eager investigations to solve the above-mentioned problems. As a result, the inventors have found out that by adjusting the surface roughness of a resistance heating element formed on the surface of a ceramic heater, the surface area of the resistance heating element is enlarged and the temperature of the resistance heating element drops rapidly at the time of cooling the resistance heating element because the rough face functions similarly to heat-radiating fins, so that the temperature of the ceramic heater can be rapidly lowered.

Furthermore, the inventors have found out that cracks generated when the insulating covering layer is formed on the resistance heating element result from poor adhesiveness between the covering layer and the resistance heating element and such problems can be solved by giving a certain value to the surface roughness of the resistance heating element. Thus, the inventors have made the present invention.

That is, the present invention is a ceramic heater for a semiconductor-producing/examining device (hereinafter simply referred to as a ceramic heater) comprising a resistance heating element on a surface thereof,
wherein
the resistance heating element has a surface roughness Ra according to JIS B 0601 of 0.01 µm or more.

Since the surface roughness Ra according to JIS B 0601 of the surface of the resistance heating element is adjusted to 0.01 µm or more in the above-mentioned ceramic heater, the rough face formed on the surface of this resistance heating element functions as heat-radiating fins when a cooling medium is present around the resistance heating element. Thus, the resistance heating element is rapidly cooled. As a result, the temperature of the ceramic heater can be rapidly lowered.

In the ceramic heater for a semiconductor-producing/examining device of the present invention, the surface roughness Ra according to JIS B 0601 of the resistance heating element is preferably from 0.05 to 15 µm.

In the ceramic heater for a semiconductor-producing/examining device of the present invention, it is also desirable that an insulating covering layer is formed on the above-mentioned resistance heating element.

Even if the insulating covering layer is formed, the insulating covering layer and the resistance heating element adhere firmly to each other since the surface of the resistance heating element is a rough face. Thus, cracks caused by a heat cycle are not generated. As a result, it is possible to prevent the oxidation and/or sulfurization of the resistance heating element.

### Brief Description of the Drawings

Fig. 1 is a bottom view which schematically illustrates one example of a ceramic heater according to the present invention.
Fig. 2 is a partially enlarged cross section view of the ceramic heater illustrated in Fig. 1.
Fig. 3 is a cross section view which schematically illustrates the case in which the ceramic heater illustrated in Fig. 1 is set into a supporting case.
Fig. 4 is a cross section view which schematically illustrates one example of the case in which the ceramic heater of the present invention is used as an electrostatic chuck.
Fig. 5 is a horizontal cross section view which schematically illustrates the shape of an electrostatic electrode constituting the electrostatic chuck according to the present invention.
Fig. 6 is a horizontal cross section view which schematically illustrates the shape of an electrostatic electrode constituting the electrostatic chuck according to the present invention.
Fig. 7 is a horizontal cross section view which schematically illustrates the shape of an electrostatic electrode constituting the electrostatic chuck according to the present invention.
Fig. 8 is a cross section view which schematically illustrates one example of the case in which the ceramic heater of the present invention is used as a chuck top plate for a wafer prober.
Fig. 9 is a plan view which schematically illustrates the chuck top plate used in the wafer prober of Fig. 8.
Figs. 10(a) to (d) are cross section views which schematically illustrate some parts of the manufacturing process of the ceramic heater illustrated in Fig. 1.
Fig. 11 is a chart illustrating the surface roughness of the surface of a resistance heating element formed on a ceramic heater according to Example 1.
Fig. 12 is a chart illustrating the surface roughness of the surface of a resistance heating element formed on a ceramic heater according to Example 2.

### Explanation of Numerals

- 10: ceramic heater
- 11, 41, 73: ceramic substrate
- 11a: heating face
- 11b: bottom face
- 12, 45, 85: resistance heating element
- 120: metal covering layer
- 13: external terminal
- 36: lifter pin
- 39: semiconductor wafer
- 42, 52, 62: chuck positive electrostatic layer
- 43, 53, 63: chuck negative electrostatic layer
- 44: ceramic dielectric film
- 70: chuck top plate for a wafer prober
- 72: chuck top plate
- 75: guard electrode
- 76: ground electrode
- 77: groove
- 86, 87: conductor-filled through hole
- 90: supporting case
- 91: heat-insulating member
- 91a: substrate-receiving section
- 92: supporting case body
- 95: opening
- 97: metal member for pressing
- 98: bolt
- 99: gas-introducing pipe

### Detailed Disclosure of the Invention

A ceramic heater for a semiconductor-producing/examining device of the present invention comprises a resistance heating element on a surface thereof,
wherein
the resistance heating element has a surface roughness Ra according to JIS B 0601 of 0.01 µm or more.

According to the ceramic heater for a semiconductor-producing/examining device of the present invention, the surface roughness Ra according to JIS B 0601 of the surface of the resistance heating element is adjusted to 0.01 µm or more; therefore, the rough face formed on the surface of resistance heating element functions as heat-radiating fins when a cooling medium is present around this resistance heating element so that the resistance heating element is rapidly cooled. As a result, the temperature of the ceramic heater can be rapidly lowered.

On the other hand, if the surface roughness according to JIS B 0601 of the surface of the resistance heating element is less than 0.01 µm, it becomes difficult to lower the temperature of the ceramic heater rapidly since the heat-radiating effect of the resistance heating element deteriorates.

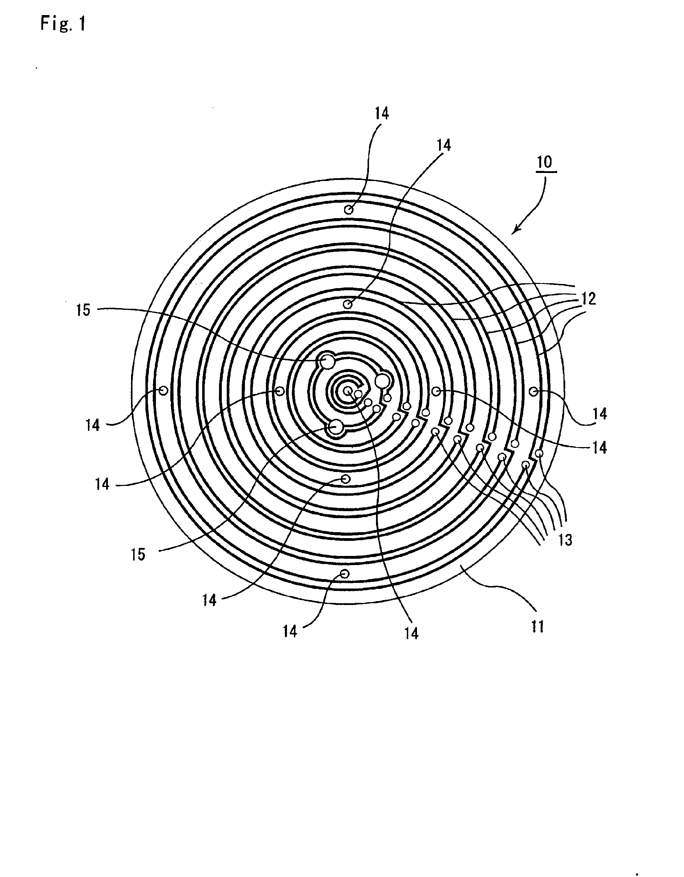

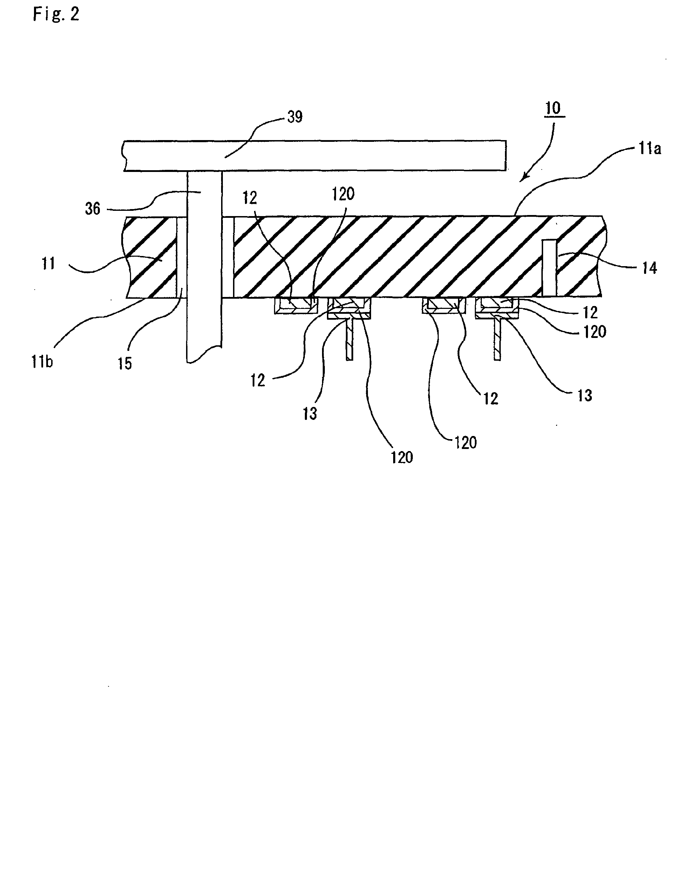

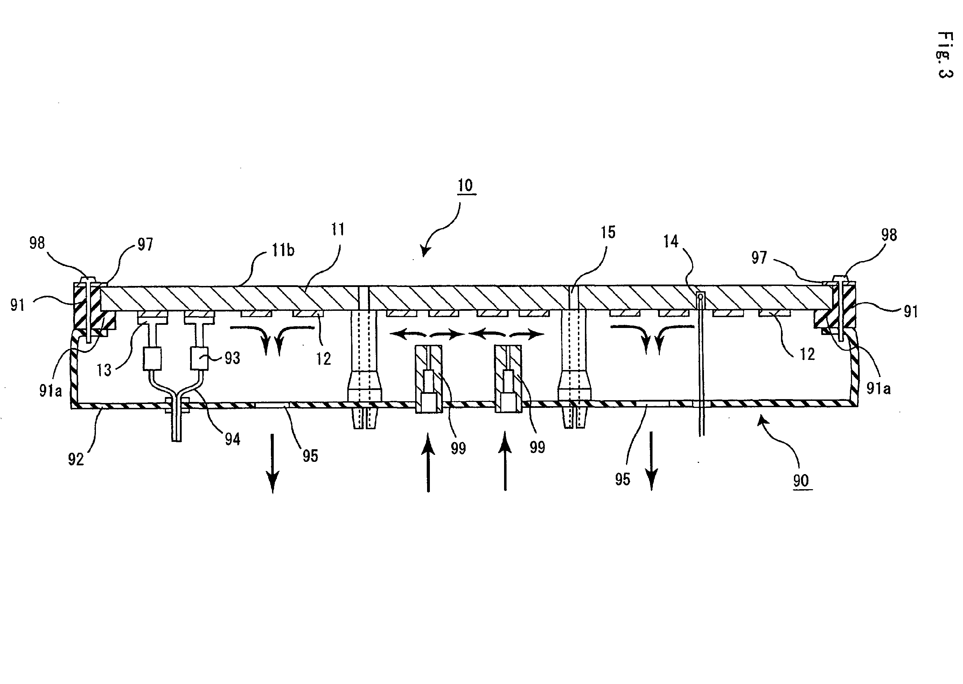

Fig. 1 is a bottom view which schematically illustrates a ceramic heater of the present invention, and Fig. 2 is a cross section view which schematically illustrates one portion of the ceramic heater illustrated in Fig. 1. Fig. 3 is a cross section view which schematically illustrates a hot plate unit having the ceramic heater illustrated in Figs. 1 and 2. In this ceramic heater, resistance heating elements are formed on the surface of the ceramic substrate.

As illustrated in Fig. 1, a ceramic substrate 11 is formed in a disc form. In order to perform heating in such a manner that the temperature of the whole of a heating face 11a of the ceramic substrate will be uniform, resistance heating elements 12 having a pattern of concentric circle are formed on a bottom face 11b of the ceramic substrate 11. On the surface thereof, a metal covering layer 120 is formed.

External terminals 13, which will be terminals for input and output, are connected through the metal covering layer 120 to both ends of each of the resistance heating elements 12. To the external terminal 13 is fitted, for example, a socket (not illustrated) having a conductor wire. This conductor wire is connected to, for example, a power source and so on.

At portions near the center of the ceramic substrate 11, through holes 15, into which lifter pins 36 for carrying a semiconductor wafer 39 will be inserted, are formed.
Furthermore, bottomed holes 14, into which temperature-measuring elements (not illustrated) will be inserted, are formed.

A substrate-receiving section 91a for supporting the ceramic substrate 11 having the resistance heating elements 12 is integrated with the lower inside of a heat-insulating member 91 fitted to the upper portion of a supporting case 90. A supporting case body 92 having the shape of a bottomed cylinder is fitted and fixed onto the lower face of the heat-insulating member 91 with bolts 98.

The bolts 98 also have a function of fixing a metal member 97 forpressing. By the metal member 97 for pressing, the ceramic substrate 11 fitted into the heat-insulating member 91 is pressed against the substrate-receiving section 91a and fixed.

A gas-introducing pipe 99 is fitted to the bottom of the supporting case body 92, and a heating medium or a cooling medium is introduced to the inside of the supporting case 90 through this gas-introducing pipe 99.

After the heating medium or the cooling medium, which is introduced into the supporting case 90, cools or heats the ceramic substrate 11 and the resistance heating elements 12, the medium passes through an opening 95 made in the bottom of the supporting case body 92 and is then discharged outside.

The pattern of the resistance heating elements formed in the ceramic heater of the present invention is not limited to the concentric pattern illustrated in Fig. 1, and may for example be a spiral pattern, a pattern comprising repeated circular arcs, a pattern comprising repeated winding lines, and the like; the pattern is not particularly limited. These patterns may be formed alone or in any combination.

Resistance heating elements comprising at least two divided circuits are desirable. By dividing circuits, electric powers applied to the respective circuits can be controlled so that the calorific value can be changed and the temperature of the face for heating the silicon wafer can be adjusted.

The thickness of the resistance heating elements is preferably from 1 to 30 µm, more preferably from 1 to 10 µm. The width of the resistance heating elements is preferably from 0.1 to 20 mm, more preferably from 0.1 to 5 mm.

The resistance values of the resistance heating elements can be changed depending on their widths and thicknesses. However, the above-mentioned ranges are most practical.

The section shapes of the resistance heating elements may be rectangular or elliptical, but desirably flat. From the flat section, heat is more easily radiated toward the heating face. Thus, a temperature distribution in the heating face is not easily generated.

The aspect ratio (the width of the resistance heating element/the thickness of the resistance heating element) of the section is desirably from 10 to 5000.

Adjustment thereof into this range makes it possible to increase the resistance value of the resistance heating elements and keep the uniformity of the temperature in the heating face.

In the case that the thickness of the resistance heating elements is made to be constant, the amount of heat propagation to the direction of the heating face of the ceramic substrate becomes small if the aspect ratio is smaller than the above-mentioned range. Thus, a thermal distribution similar to the pattern of the resistance heating elements is generated in the heating face. On the contrary, if the aspect ratio is too large, the portions just above the centers of the resistance heating elements reach a high temperature so that a thermal distribution similar to the pattern of the resistance heating elements is generated in the heating face. Accordingly, if temperature distribution is considered, the aspect ratio of the section is preferably from 10 to 5000.

Regarding a variation in the resistance values of the resistance heating elements, a variation range of the resistance values is desirably 5% or less of the average resistance value, more desirably 1% thereof. The resistance heating elements of the present invention are plural divided circuits. By making the variation range of the resistance values as small as described above, the number of the divided resistance heating elements can be reduced so that the temperature can easily be controlled. Furthermore, the temperature of the heating face during the temperature rise can be made uniform.

Usually, such a resistance heating element is formed by: applying a conductor containing paste comprising metal particles or conductive ceramic particles for keeping conductivity on a ceramic substrate and then firing them. The resistance heating element may also be formed by physical vapor deposition such as plating or sputtering. In the case of plating, the resistance heating element can be formed by forming a plating resist. In the case of sputtering and the like, the resistance heating element can be formed by performing selective etching.

The surface roughness Ra according to the JIS B 0601 of the resistance heating element is 0.01 µm or more. The surface roughness is preferably from 0.05 to 15 µm. When the temperature of the ceramic heater is lowered, a temperature difference between a cooling medium to be supplied and the resistance heating element is very large. Therefore, when the surface roughness Ra is adjusted to 0.01 µm or more, the rough face formed in the resistance heating element functions as heat-radiating fins. Thus, the contact area between the cooling medium and the resistance heating element can be made large and heat exchange between the cooling medium and the resistance heating element can be very effectively performed. Consequently, the temperature of the ceramic substrate can be rapidly lowered.

When the rough face is formed in the resistance heating element, the resistance heating element has a high heat-radiating effect. Therefore, it is apprehended that when the temperature thereof is raised, the heating efficiency deteriorates. However, the ceramic heater of the present invention is usually held in the supporting case and used as illustrated in Fig. 3, and when the temperature of the resistance heating element is raised, gas around the resistance heating element remains in the supporting case. As a result, the temperature of the gas around the resistance heating element follows the temperature of the resistance heating element so that the temperature of the gas rises. Thus, a temperature difference between the resistance heating element on a higher temperature side and the gas around the resistance heating element on a lower temperature side becomes very small. Therefore, heat exchange between the two is not performed very much. Consequently, the heating efficiency of the ceramic heater of the present invention does not deteriorate very much when the temperature thereof is raised.

However, if the surface roughness Ra is 20 µm or more, the resistance heating element comes to have a very high heat-radiating effect. For this reason, the resistance heating element can be rapidly cooled. However, it is apprehended that the heating efficiency deteriorates.

The method of forming a resistance heating element having such a rough face will be described in detail later. In the case in which a conductor containing paste is applied to a ceramic substrate and then sintered, the surface roughness of the resultant conductor layer can be adjusted by selecting the shape or the average particle diameter of metal particles, which constitute a starting material of the resistance heating element. When a resistance heating element is formed by plating, the surface roughness can be adjusted by selecting, for example, conditions for precipitating an acicular crystal and then performing the plating.

The conductor containing paste is not particularly limited, but is preferably a paste comprising not only the metal particles or the conductive ceramic but also a resin, a solvent, a thickener and so on.

The above-mentioned metal particles are preferably made of, for example, a noble metal (gold, silver, platinum or palladium), lead, tungsten, molybdenum, nickel and the like. These may be used alone or in combination of two or more kinds thereof. These metals are not relatively easily oxidized, and have a resistance value sufficient for generating a heat.

Examples of the above-mentioned conductive ceramic include carbides of tungsten and molybdenum and the like. These may be used alone or in combination of two or more.

The particle diameter of these metal particles or the conductive ceramic particles is preferably from 0.1 to 100 µm. If the particle diameter is too small, that is, less than 0.1 µm, the roughness Ra of the surface of the resistance heating element is liable to be less than 0.01 µm so that the heat-radiating function of the resistance heating element deteriorates. As a result, it becomes difficult to lower the temperature of the ceramic heater rapidly. On the other hand, if the particle diameter of the metal particles and the like is over 100 µm, they are not easily sintered so that the resistance value becomes too large.

The shape of the metal particles may be spherical or scaly. Spherical particles are more preferable, because the surface of the resistance heating element is easily made coarser. Scaly particles whose aspect ratio (width or length/thickness) is not very large are liable to become perpendicular or oblique to the face on which the resistance heating element is formed; therefore, the roughness of the surface can be made large.

When these metal particles are used, they may be a mixture of spherical particles and scaly particles.

In the case that the metal particles are scaly or a mixture of spherical particles and scaly particles, metal oxides among the metal particles are easily held and adhesiveness between the resistance heating element and a nitride ceramic and the like is made sure. Moreover, the resistance value can be made large. Thus, this case is profitable.

Furthermore, acicular particles whose aspect ratio (length to diameter) is not very large are liable to become perpendicular or oblique to the face on which the resistance heating element is formed, as well. Therefore, the roughness of the surface can be made large.

Examples of the resin used in the conductor containing paste include epoxy resins, phenol resins and the like. Examples of the solvent include isopropyl alcohol and the like. Examples of the thickener include cellulose and the like.

It is desirable to use, as the conductor containing paste, a paste wherein a metal oxide is added to the metal particles, and apply this onto the ceramic substrate and subsequently sinter the metal particles and the like and the metal oxide. This is because by sintering the metal oxide together with the metal particles in this way, the nitride ceramic and the like constituting the ceramic substrate can be closely adhered to the metal particles.

The reason why the adhesiveness to the nitride ceramic and the like is improved by mixing the metal oxide is unclear, but would seem to be based on the following. The surface of the metal particles or the surface of the nitride ceramic and the like is slightly oxidized so that oxidized films are formed. The oxidized films are sintered and integrated with each other through the metal oxide so that the metal particles and the nitride ceramic and the like are closely adhered to each other. In the case in which the ceramic constituting the ceramic substrate is an oxide ceramic, the surface thereof is naturally made of the oxide. Therefore, a conductor layer having a superior adhesiveness is formed.

A preferred example of the metal oxide is at least one selected from the group consisting of lead oxide, zinc oxide, silica, boron oxide (B₂O₃), alumina, yttria, and titania.

These oxides make it possible to improve adhesiveness between the metal particles and the nitride ceramic and the like without increasing the resistance value of the resistance heating elements 12.

When the total amount of the metal oxides is set to 100 parts by weight, the weight ratio of above-mentioned lead oxide, zinc oxide, silica, boron oxide (B₂O₃), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. This ratio is desirably adjusted within the scope that the total ratio of the oxides is not over 100 parts by weight. By adjusting the amounts of these oxides within these ranges, the adhesiveness to the nitride ceramic and the like can be particularly improved. The addition amount of the metal oxides to the metal particles is preferably 0.1% or more by weight and less than 10% by weight.

The area resistivity when the conductor containing paste having such a constitution is used to form the resistance heating elements 12 is preferably from 1 mΩ/□ to 10 Ω/□ .

If the area resistivity is less than 1 mΩ/□ , the resistivity is too small so that calorific value also becomes small. Thus, the resistance heating elements do not exhibit their original function easily. On the other hand, if the area resistivity is more than 10Ω/□, calorific value for an applied voltage becomes too large so that in the ceramic heater 10, wherein the resistance heating elements 12 are formed on the surface of the ceramic substrate 11, their calorific value is not easily controlled.

From the viewpoint of the controllability of the calorific value, the area resistivity of the resistance heating elements is more preferably from 1 to 50 mΩ/□ . However, if the area resistivity is made large, the pattern width (sectional area) can be made large so that a problem of wire disconnection is not easily generated. As the case may be, therefore, the area resistivity is preferably set to 50 mΩ/□ or more.

The resistance heating elements are desirably covered with an insulating covering layer. This is because the oxidation or sulfurization of the resistance heating elements can be prevented. As the insulating covering layer, oxide glass, a resin and the like can be used. Examples of oxide glass include ZnO-B₂O₃-SiO₂, PbO-SiO₂, PbO-B₂O₃-SiO₂, PbO-ZnO-B₂O₃ and the like. These oxide glass materials may contain a crystalline portion. The glass transition point of these glass materials is from 400°C to 700°C, and the thermal expansion coefficient thereof is from 4 to 9 ppm/°C.

Examples of the resin include polyimide resin and silicone resin and the like. The polyimide resin is a macromolecular compound obtained by reaction of a carboxylic acid derivative with a diamine. The silicone resin is a resin wherein a methyl or ethyl group is arranged as an alkyl group of a side chain of polysiloxane.

The thickness of the insulating covering layer is desirably from 5 to 100 µm.

In the case in which such an insulating covering layer is formed, the surface roughness Ra of the resistance heating elements is desirably from 0.05 to 15 µm. This is because the resistance heating elements are strongly integrated with the insulating covering layer so that no cracks are generated in the insulating covering layer by a heat cycle. If the Ra is less than 0.05 µm, the insulating covering layer moves by the heat expansion caused by a heat cycle so that a crack is generated. If the Ra is more than 15 µm, a crack is generated from the tip of a mountain of the rough face.

In the case that the above-mentioned insulating covering layer is not formed on the resistance heating elements, a metal covering layer is desirably formed on the surface portion of the resistance heating elements. This is because a change in the resistance value, caused by the oxidation of the inner metal sintered body, is prevented. At this time, the surface roughness Ra of the metal covering layer to be formed is set to 0.01 µm or more. The thickness thereof is preferably from 1 to 100 µm. When the metal covering layer is formed by plating, the surface roughness can be adjusted by selecting conditions for precipitating an acicular crystal and then performing the plating. Furthermore, the surface roughness may be adjusted by forming a thick plating layer and subsequently performing etching. As the case may be, it is allowable to form the metal covering layer on the surface of the resistance heating elements and form the insulating covering layer thereon. This is because the resistance heating elements can be more completely protected.

Therefore, the surface area of the resistance heating elements can be made larger, for example, by forming the resistance heating elements having some degree of surface roughness by screen printing and the like, and subsequently forming a plating layer made of an acicular crystal, or by forming a plating layer having a large thickness and subsequently etching the layer.

The metal used when the metal covering layer is formed is not particularly limited if the metal is a non-oxidizable metal. Specifically, examples thereof include gold, silver, palladium, platinum, nickel and the like. These may be used alone or in combination of two or more kinds thereof. Among these, nickel is preferable.

The resistance heating element requires a terminal to connect itself to a power source. This terminal is fixed to the heating element through solder. Nickel prevents solder from being thermally diffused. An example of the connecting terminal is a terminal made of Kovar.

The ceramic substrate used in the ceramic heater of the present invention is desirably in a disc form. The diameter thereof is desirably more than 200 mm. This is because a semiconductor wafer having a large diameter can be put onto the substrate having such a large diameter. It is particularly desirable that the diameter of the ceramic substrate is 12 inches (300 mm) or more. Such a ceramic substrate will be suitable for the mainstream of semiconductor wafers in the next generation.

The thickness of the above-mentioned ceramic substrate is desirably 25 mm or less. If the thickness of the ceramic substrate ismore than 25mm, the temperature-following character deteriorates. The thickness thereof is desirably 0.5 mm or more. If the thickness is less than 0.5 mm, the strength itself of the ceramic substrate drops so that the ceramic substrate may easily be broken down. More desirably, the thickness is above 1.5 mm and 5 mm or less. If the thickness is more than 5 mm, heat is not easily conducted so that heating efficiency tends to drop. On the other hand, if the thickness is 1.5 mm or less, heat conducted in the ceramic substrate does not diffuse sufficiently so that a variation in temperature may be generated in the heating face. Moreover, the strength of the ceramic substrate drops so that the ceramic substrate may be broken down.

In the ceramic heater 10 of the present invention, it is desirable that bottomed holes 14 are made, from the side opposite to the heating face 11a on which an object to be heated will be put toward the heating face 11a, in the ceramic substrate 11. Additionally, it is desirable that the bottomof the bottomed holes 14 is formed nearer to the heating face 11a than the resistance heating elements 12 and temperature-measuring elements (not illustrated), such as thermocouples, are set up into the bottomed holes 14.

The distance between the bottoms of the bottomed holes 14 and the heating face 11a is desirably from 0.1 mm to 1/2 of the thickness of the ceramic substrate.

In this way, temperature-measuring positions are nearer to the heating face 11a than the resistance heating elements 12, so that the temperature of the semiconductor wafer can be more precisely measured.

If the distance between the bottoms of the bottomed holes 14 and the heating face 11a is less than 0.1 mm, heat is radiated so that temperature distribution is formed in the heating face 11a. If the distance is over 1/2 of the thickness, the ceramic substrate is easily affected by the temperature of the resistance heating elements so that temperature-control cannot be performed. Thus, temperature distribution is formed in the heating face 11a, as well.

The diameter of the bottomed holes 14 desirably ranges from 0.3 mm to 5 mm. If the diameter is too large, heat-radiating property enhances. If the diameter is too small, workability deteriorates so that the distance to the heating face 11a cannot be made uniform.

As illustrated in FIG. 1, a plurality of bottomed holes 14 are desirably arranged symmetrically about the center of the ceramic substrate 11 and arranged into a cross form. This is because the temperature of the whole of the heating face can be measured.

Examples of the above-mentioned temperature-measuring element include a thermocouple, a platinum temperature-measuring resistor, a thermistor and the like.

Examples of the above-mentioned thermocouple include K, R, B, S, E, J and T type thermocouples and the like, as described in JIS-C-1602 (1980). Among these, the K type thermocouple is preferable.

Desirably, the size of the connecting portions of the thermocouple is equal to or larger than the strand diameter of the thermocouple, and is 0.5 mm or less. If the connecting portion is large, the heat capacity is large so that the response is slow. It is difficult to make size smaller than the strand diameter of the thermocouple.

The above-mentioned temperature-measuring elements may be bonded to the bottoms of the bottomed holes 14 with brazing gold, brazing silver and the like, or may be inserted into the bottomed holes 14 and then sealed with a heat-resistant resin. The two may be used together.

Examples of the above-mentioned heat-resistant resin include thermosetting resins, particularly epoxy resin, polyimide resin, bismaleimide-triazine resin and the like. These resins may be used alone or in combination of two or more kinds thereof.

As the above-mentioned brazing gold, desirable is at least one selected from an alloy of 37 to 80.5% by weight of Au and 63 to 19.5% by weight of Cu, and an alloy of 81.5 to 82.5% by weight of Au and 18.5 to 17.5% by weight of Ni. These have a melting temperature of 900°C or more, and do not melt easily in high temperature regions.

Examples of the brazing silver that can be used include Ag-Cu alloys.

The ceramic which forms the ceramic heater of the present invention is desirably a nitride ceramic or a carbide ceramic.

The nitride ceramic or the carbide ceramic has a smaller thermal expansion coefficient than metals and has a far higher mechanical strength than metals. Therefore, even if the thickness of the ceramic substrate is made small, the ceramic substrate is not warped or distorted by heating. For this reason, the ceramic substrate can be made thin and light. Since the ceramic substrate has a high thermal conductivity and the ceramic substrate itself is thin, the surface temperature of the ceramic substrate follows a change in the temperature of the resistance heating elements rapidly. That is, by changing a voltage or electric current value to change the temperature of the resistance heating elements, the surface temperature of the ceramic substrate can be controlled.

Examples of the above-mentioned nitride ceramic include aluminum nitride, silicon nitride, boron nitride, titanium nitride and the like. These maybe used alone or in combination of two or more kinds thereof.

Examples of the carbide ceramic include silicon carbide, zirconium carbide, titanium carbide, tantalum carbide, tungsten carbide and the like. These maybe used alone or in combination of two or more kinds thereof.

Among these, aluminum nitride is most preferred. This is because it has the highest thermal conductivity, that is, 180 W/m · K and it has superior temperature-following character.

When a nitride ceramic or a carbide ceramic and the like is used as the ceramic substrate, an insulating layer may be formed if necessary. Regarding a nitride ceramic, the volume resistance value thereof drops easily at high temperature by solid solution of oxygen and the like. A carbide ceramic has an electric conductivity unless the ceramic is particularly made to be of high purity. By forming the insulating layer, a short between the circuits is prevented at high temperature or even if it contains impurities. Thus, temperature-controllability can be ensured.

The above-mentioned insulating layer is desirably an oxide ceramic. Specifically, silica, alumina, mullite, cordierite, beryllia and the like can be used.

Such an insulating layer may be formed by spin-coating the ceramic substrate with a sol solution wherein an alkoxide is hydrolyzed and polymerized, and then drying and firing the solution, or by sputtering, CVD and the like. The surface of the ceramic substrate may be subjected to oxidation-treatment to deposit an oxide layer.

The above-mentioned insulating layer is desirably from 0.1 to 1000 µm thick. If the thickness thereof is less than 0.1 µm, insulation cannot be ensured. If the thickness is over 1000 µm, heat conductivity from the resistance heating elements to the ceramic substrate is hindered.

Furthermore, the volume resistivity of the above-mentioned insulating layer is desirably 10 or more times larger than that of the above-mentioned ceramic substrate (at the same measurement temperature), because, in the case of less than 10 times, a short between the circuits cannot be prevented.

The ceramic substrate used in the ceramic heater of the present invention desirably contains carbon. The content thereof is desirably from 200 to 5000 ppm. This is because the electrode can be concealed and black-body radiation is easily used.

The brightness of the above-mentioned ceramic substrate is desirably N6 or less as a value according to the definition of JIS Z 8721. This is because the ceramic substrate having a brightness of this degree is superior in heat radiation capacity and electrode-concealing ability.

The brightness N is defined as follows: the brightness of ideal black is made to 0; that of ideal white is made to 10; respective colors are divided into 10 parts in the manner that the brightness of the respective colors is recognized stepwise between the brightness of black and that of white at equal intensity intervals; and the resultant parts are indicated by symbols N0 to N10, respectively.

Actual brightness is measured by comparison with color chips corresponding to N0 to N10. One place of decimals in this case is made to 0 or 5.

In the case in which an electrostatic electrode layer is formed inside the ceramic substrate in the ceramic heater of the present invention, the ceramic heater of the present invention functions as an electrostatic chuck. In this case, the ceramic substrate constituting this electrostatic chuck is made in substantially the same way as the above-mentioned ceramic heater except that an electrostatic electrode is formed.

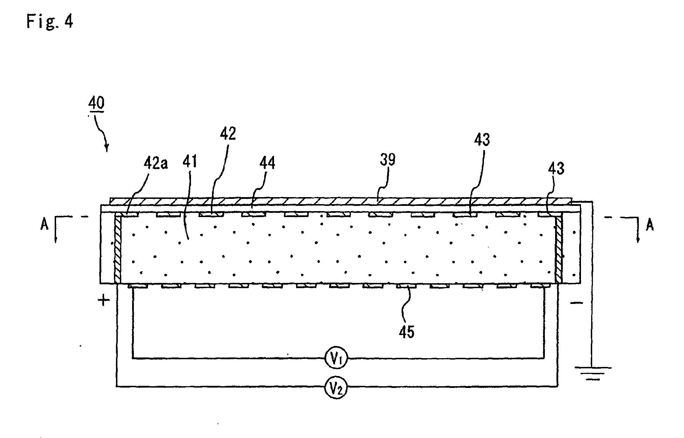

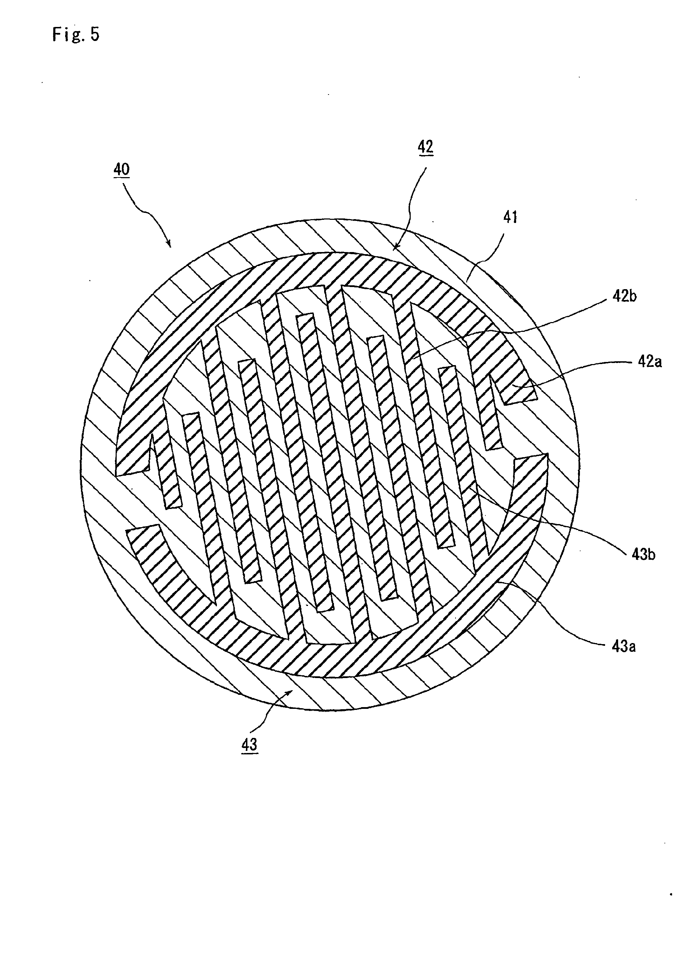

Fig. 4 is a vertical cross section view schematically illustrating an embodiment of an electrostatic chuck according to the present invention, and Fig. 5 is a cross section view taken on A-A line of the electrostatic chuck illustrated in Fig. 4.

In this electrostatic chuck 40, an electrostatic electrode layer comprising a chuck positive electrostatic layer 42 and a chuck negative electrostatic layer 43 is embedded in a ceramic substrate 41. A thin ceramic layer 44 (hereinafter referred to as a ceramic dielectric layer) is formed on this electrostatic electrode layer. A silicon wafer 39 is put on the electrostatic chuck 40 and grounded.

As illustrated in FIG. 5, the chuck positive electrostatic layer 42 comprises a semicircular arc part 42a and a comb teeth shaped part 42b. Likewise, the chuck negative electrostatic layer 43 comprises a semicircular arc part 43a and a comb teeth shaped part 43b. The chuck positive electrostatic layer 42 and chuck negative electrostatic layer 43 are arranged face-to-face in such a manner that the teeth of one comb teeth shaped part 42b extend in staggered relation with the teeth of the other comb teeth shaped part 43b. The + side and the - side of a direct current power source are connected to the chuck positive electrostatic layer 42 and chuck negative electrostatic layer 43, respectively, so that a direct current voltage V₂ is applied thereto.

In order to control the temperature of the semiconductor wafer 39, resistance heating elements 45 in the formof concentric circles as viewed from the above, as illustrated in FIG. 1, are formed on the ceramic substrate 41. Regarding the surface of the resistance heating elements 45, its surface roughness Ra according to JIS B 0601 is adjusted to 0.01 µm or more. External terminals are connected and fixed to both ends of each of the resistance heating elements 45, and a voltage V₁ is applied thereto. Although not illustrated in Figs. 4 and 5, bottomed holes, into which temperature-measuring elements will be inserted, and through holes, through which lifter pins that support the silicon wafer 39 and move it up and down are inserted, are formed in the ceramic substrate 41.

When this electrostatic chuck 40 is caused to work, a direct current voltage V₂ is applied to the chuck positive electrostatic layer 42 and the chuck negative electrostatic layer 43. In this way, the semiconductor wafer 39 is adsorbed and fixed onto the chuck positive electrode and the chuck negative electrode through the ceramic dielectric film 44 by electrostatic effect of the chuck positive electrostatic layer 42 and the chuck negative electrostatic layer 43. The semiconductor wafer 39 is fixed onto the electrostatic chuck 40 in this way, and subsequently the semiconductor wafer 39 is subjected to various treatments such as CVD.

In the electrostatic chuck according to the present invention, the rough face formed on the surface of the resistance heating elements functions as heat-radiating fins in the same way as in the above-mentioned ceramic heater when a cooling medium is present around the resistance heating elements. Thus, the electrostatic chuck is rapidly cooled. As a result, the temperature of the electrostatic chuck can be rapidly lowered.

Examples of the above-mentioned electrostatic electrodes include a sintered body of a metal or a conductive ceramic; a metal foil; and the like. As the metal sintered body, at least one selected from tungsten and molybdenum is preferred. The metal foil is desirably made of the same material for the metal sintered body. These metals are relatively not easily oxidized and have a sufficient conductivity for electrodes. As the conductive ceramic, at least one selected from carbides of tungsten and molybdenum can be used.

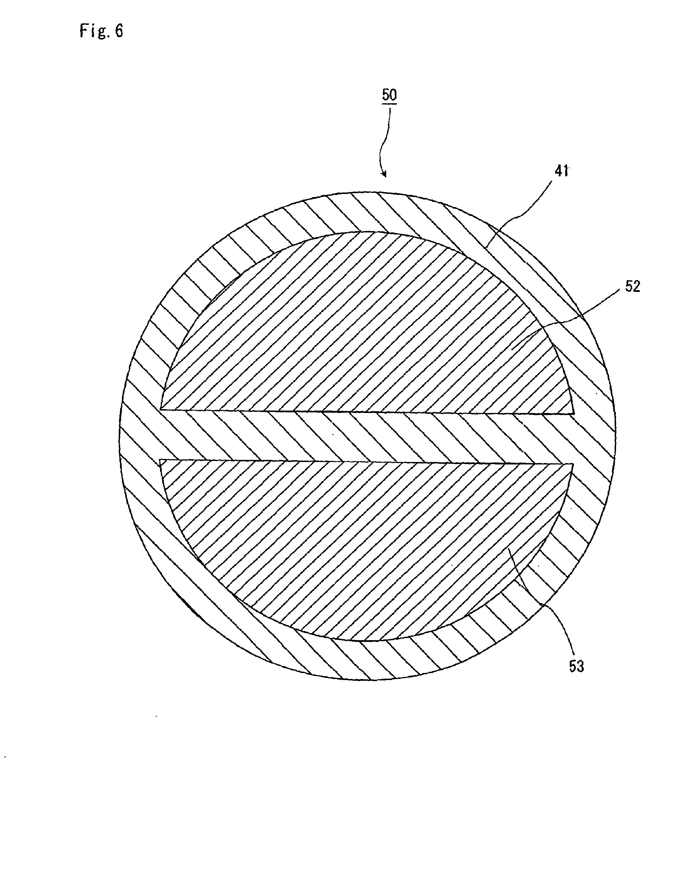

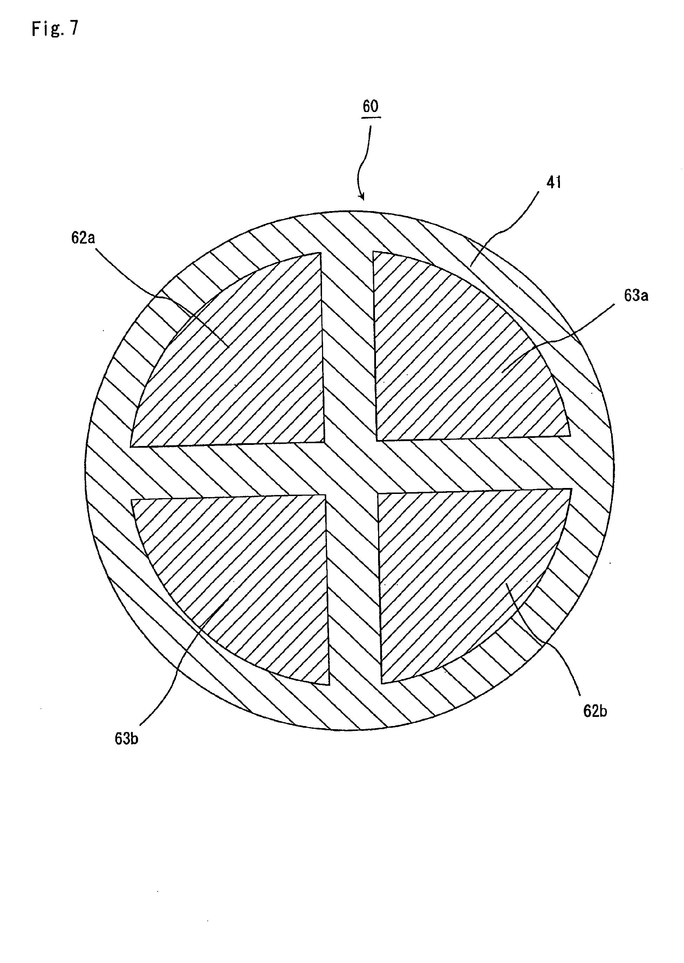

Figs. 6 and 7 are horizontal cross section views, each of which schematically illustrates electrostatic electrodes in a different electrostatic chuck. In an electrostatic chuck 50 illustrated in FIG. 6, a chuck positive electrostatic layer 52 and a chuck negative electrostatic layer 53 in a semicircular form are formed inside a ceramic substrate 41. In an electrostatic chuck 60 illustrated in FIG. 7, chuck positive electrostatic layers 62a and 62b and chuck negative electrostatic layers 63a and 63b, each of which is quartered-circle shaped, are formed inside a ceramic substrate 41. The two chuck positive electrostatic layers 62a and 62b and the two chuck negative electrostatic layers 63a and 63b are formed to cross each other.

When the electrodes are formed in segments of a circle, for instance, the number of segments is not particularly limited and may be 5 or more. The shape thereof is not limited to a sector.

In a ceramic heater of the present invention, by depositing a chuck top conductor layer on the surface of the ceramic substrate and disposing guard electrodes and ground electrodes and the like inside of the ceramic substrate, the resultant ceramic heater of the present invention functions as a chuck top plate for a wafer prober.

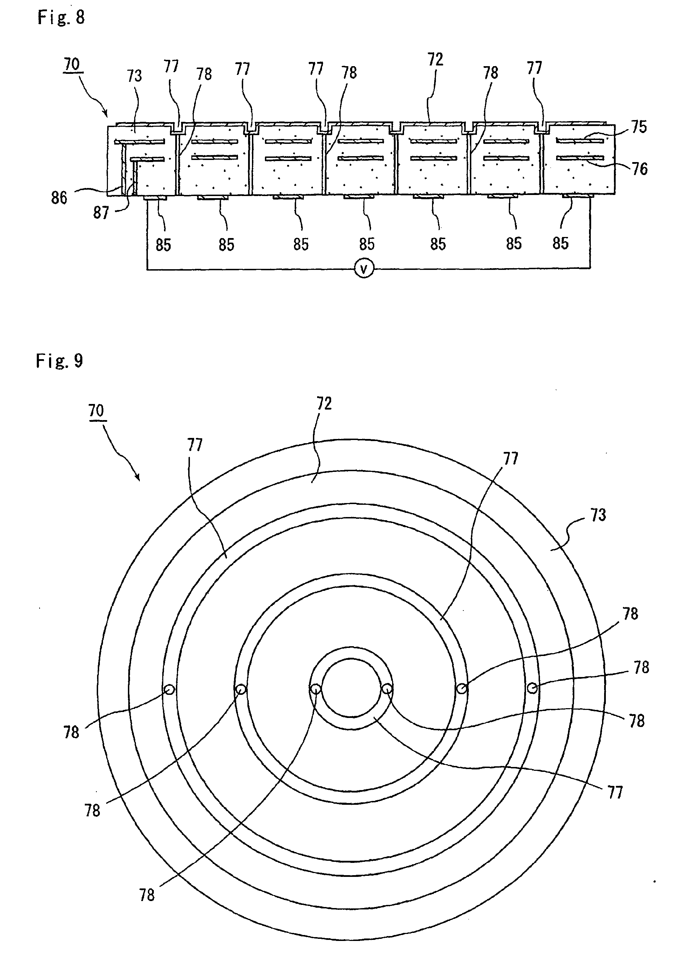

FIG. 8 is a cross section view which schematically illustrates a chuck top plate for a wafer prober according to the present invention. FIG. 9 is a plan view which schematically illustrates the chuck top plate for a wafer prober illustrated in FIG. 8.

In the chuck top plate for a wafer prober (hereinafter referred to also as the wafer prober) 70, grooves 77 in the form of concentric circles are formed on the surface of a disc-form ceramic substrate 73. Moreover, plural suction holes 78 for sucking a silicon wafer are made in some parts of the grooves 7. A chuck top conductor layer 72 for connecting electrodes of the semiconductor wafer is formed, in a circular form, in the greater part of the ceramic substrate 73 including the grooves 77. A semiconductor wafer is put on this chuck top conductor layer and a probe card having a tester pin is pressed against it, whereby a continuity test is performed.

In order to control the temperature of the silicon wafer, resistance heating elements 85 as illustrated in Fig. 1, in the form of concentric circles as viewed from the above, are made on the bottom face of the ceramic substrate 73. Regarding the surface of the resistance heating elements 85, their surface roughness Ra according to JIS B 0601 is adjusted to 0.01 µm or more. External terminals (not illustrated) are connected and fixed to both ends of the resistance heating elements 85. Guard electrodes 75 for canceling stray capacitor lying in the measuring-circuit are formed in the ceramic substrate 73, and a ground voltage of the measuring-circuit (that is, the chuck top conductor layer 72) is given thereto. Ground electrodes 76 are formed to cancel noises from temperature-controlling means.

In the wafer prober according to the present invention, the rough faces formed on a surface of the resistance heating elements function as heat-radiating fins in the same way as in the above-mentioned ceramic heater when a cooling medium is present around the resistance heating elements. Thus, the wafer prober is rapidly cooled. As a result, the temperature of the wafer prober can be rapidly lowered.

The thickness of the chuck top conductor layer 72 is desirably from 1 to 20 µm. As the chuck top conductor layer, there can be used, for example, at least one metal selected from high melting point metals such as copper, titanium, chromium, nickel, noblemetals (gold, silver, platinum and so on), tungsten, molybdenum and the like.

A noble metal layer (not illustrated) is formed on the chuck top conductor layer 72, and the noble metal layer prevents diffusion of boron or phosphorous in the chuck top conductor layer, or yttria, sodium and the like in the ceramic without hindering electrical conduction to the back face of the semiconductor wafer. As the noble metal, at least one selected from gold, silver, platinum and palladium is desirable.

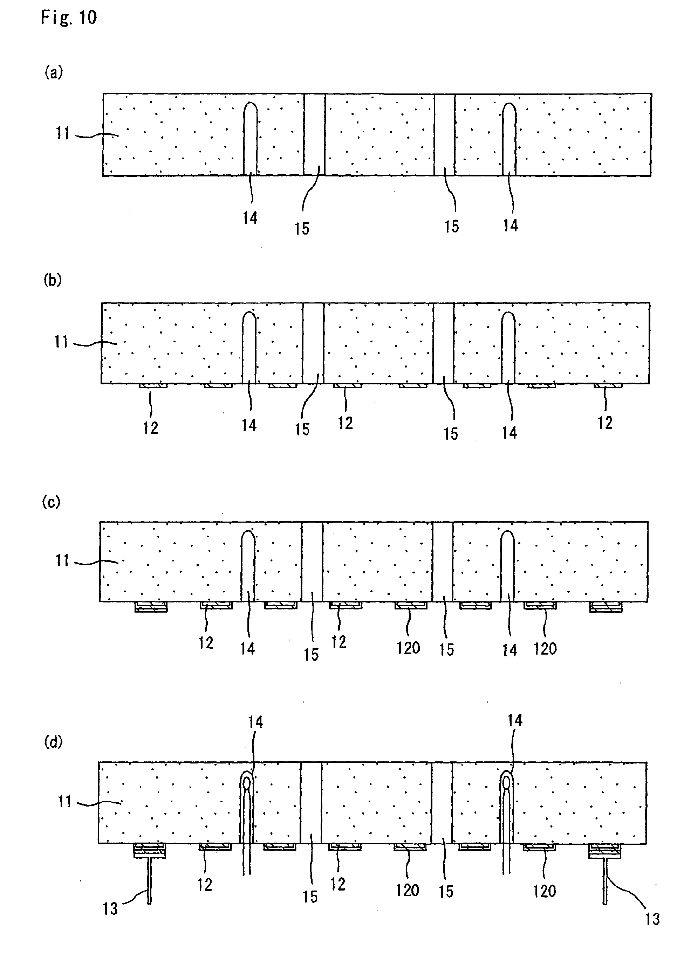

The following will describe a process for producing a ceramic heater of the present invention according to Fig. 10.
(1) Manufacturing process of a ceramic substrate
   A sintering aid such as yttria (Y₂O₃), a compound containing Na or Ca, a binder and so on are blended as appropriate with powder of a ceramic such as aluminum nitride, to prepare a slurry. Thereafter, this slurry is made into a granular form by spray-drying and the like. The granule is put into a mold and pressed to be formed into a plate form and the like. Thus, a raw formed body (green) is formed.
   The raw formed body may also be formed by laminating green sheets formed by a doctor blade method and the like.
   Next, the following portions are made in the raw formed body if necessary: portions that will be through holes 15 into which lifter pins 36 for carrying an object to be heated and the like, such as a silicon wafer 39, will be inserted; portions that will be bottomed holes 14 in which temperature-measuring elements such as thermocouples will be buried; and so on.
   Next, this raw formed body is heated and fired to be sintered. Thus, a plate made of the ceramic is manufactured. Thereafter, the plate is made into a given shape to produce a ceramic substrate 11 (see Fig. 10(a)). The shape of the raw formed body may be such a shape that the sintered body can be used as it is. Additionally, for example, by heating and firing the raw formed body under pressure from the upper and lower sides, the ceramic substrate 11 having no pores can be manufactured. It is sufficient that the heating and the firing are performed at sintering temperature or higher. For example, for nitride ceramics, the firing temperature is from 1000°C to 2500°C.
   After the firing, the through holes 15 and the bottomed holes 14 in which the temperature-measuring elements will be inserted are usually made. The through holes 15 and so on can be formed by conducting blast treatment, such as sandblast using SiC particles and the like, after grinding the surface.
(2) Process of printing a conductor containing paste on the ceramic substrate
   A conductor containing paste is generally a highly viscous fluid comprising metal particles, a resin and a solvent. The viscosity of this conductor containing paste is preferably from 70 to 90 Pa•s. If the viscosity of the conductor containing paste is less than 70 Pa•s, the viscosity is too low to prepare a paste containing the metals and so on which have a uniform concentration. As a result, a conductor layer having a uniform thickness is not easily formed. On the other hand, if the viscosity is more than 90 Pa•s, the viscosity of the conductor containing paste is too high so that coating work becomes difficult. Thus, a conductor layer having a uniform thickness is not easily formed, either. In order to form a conductor layer having a rough face, the conductor containing paste preferably has a higher viscosity. This is because it is easy for the metals in a scaly or an acicular form to be perpendicular or oblique to the face of resistance heating elements.
   This conductor containing paste is subjected to screen-printing and the like, to form a conductor containing paste layer, which will be a pattern of resistance heating elements 12. The method of forming the resistance heating elements may be the method of using the conductor containing " paste, or a method of forming a plating layer by plating and then firing the layer, thereby forming the resistance heating elements. In this case, the resistance heating elements having rough faces can be formed by precipitating plating to form an acicular plating layer . In this case, it is desirable that after a thin film is formed by electroless plating and the like, an acicular plating layer is formed on this thin film by electroplating and the like. It is also allowable to form a thick plating layer and subject the layer to etching and the like, thereby forming a rough face.
   The surface roughness of the resistance heating elements is most greatly affected by the average particle diameter of the metal particles. Therefore, the surface roughness of the resistance heating elements is usually controlled by controlling the average particle diameter of the metal particles. Furthermore, the surface roughness may be adjusted by buff grinding, sandblast treatment and the like.
(3) Firing of the conductor containing paste
   The conductor containing paste layer printed on the bottom face of the ceramic substrate 11 is heated or fired to remove the resin and the solvent and further sinter the metal particles. Thus, the metal particles are baked onto the bottom face of the ceramic substrate 11 to form the resistance heating elements (see Fig. 10(b)).
   In this case, the roughness of the surface of the resistance heating elements can be adjusted by changing heating and firing conditions. The heating and firing temperature is usually from 500°C to 1000°C. By firing the paste layer at a relatively low temperature, it is possible to prevent the metal and so on from melting and the surface from being flat. Thus, the surface roughness Ra of the conductor layer can be set to 0.01 µm or more. However, if the heating and firing temperature is too low, sintering between the metals does not advance so that the resistance value of the resistance heating elements becomes too high. Therefore, it is necessary to select an appropriate firing temperature depending on the metal to be used.
(4) Forming of a metal covering layer
   A metal covering layer 120 is desirably deposited on the surface of the resistance heating elements 12, as illustrated in Fig. 2 (see Fig. 10 (c) ) . The metal covering layer 120 can be formed by electroplating, electroless plating, sputtering and the like. From the viewpoint of mass-productivity, electroless plating is optimal. Instead of the formation of the metal covering layer, the above-mentioned insulating covering layer may be formed. It is also allowable to form the metal covering layer 120 on the surface of the resistance heating elements 12 and subsequently form the insulating covering layer thereon.
(5) Fitting of terminals and so on
   Terminals (external terminals 13) for connection to a power source are fitted up to ends of the pattern of the resistance heating elements 12 with solder (see Fig. 10(d)). Thermocouples are inserted into the bottomed holes 14. The bottomed holes are sealed with a heat resistant resin such as polyimide to finish the manufacture of a ceramic heater.

A process for manufacturing an electrostatic chuck according to the present invention will be described.
(1) Process of producing green sheets
   First, powder of a ceramic such as nitride ceramic is mixed with a binder, a solvent and so on to prepare a paste. This is used to produce green sheets.
   As the above-mentioned ceramic powder such as nitride ceramic, aluminum nitride and the like can be used. If necessary, a sintering aid such as yttria or a compound containing Na or Ca may be added.
   As the binder, desirable is at least one selected from an acrylic binder, ethylcellulose, butylcellosolve, and polyvinyl alcohol.
   As the solvent, desirable is at least one selected from α-terpineol and glycol.
   A paste obtained by mixing these is molded into a sheet form by a doctor blade method, to produce a green sheet.
   The thickness of the green sheet is preferably 0.1 to 5 mm.
(2) Process of printing a conductor containing paste on the green sheet
   A conductor containing paste which contains a metal paste or a conductive ceramic, for forming a chuck positive electrostatic layer and a chuck negative electrostatic layer, is printed on the green sheet to form a conductor containing paste layer. Conductor containing paste-filled layer, which will form a conductor-filled through hole, is formed in the through holes.
   These conductor containing pastes contain the metal particles or the conductive ceramic particles.
   The average particle diameter of tungsten particles or molybdenum particles is preferably from 0.1 to 5 µm. If the average particle diameter is less than 0.1 µm or more than 5 µm, the conductor containing paste is not easily printed.
   Such a conductor containing paste may be a composition (paste) obtained by mixing, for example, 85 to 87 parts by weight of the metal particles or the conductive ceramic particles; 1.5 to 10 parts by weight of at least one binder selected from acrylic binders, ethylcellulose, butylcellosolve and polyvinyl alcohol; and 1.5 to 10 parts by weight of at least one solvent selected from α-terpineol and glycol.
(3) Process of manufacturing a ceramic substrate

Green sheets on which no conductor containing paste is printed are laminated on the upper and lower sides of the green sheet on which the conductor containing paste is printed. Thereafter, by thermal pressure-bonding, a green sheet lamination is formed. The green sheet lamination is heated and pressed so as to sinter the green sheets and the inner conductor containing paste.

The heating temperature is preferably from 1000°C to 2000°C, and the pressing pressure is preferably from 10 to 20 MPa. The heating is performed in the atmosphere of an inert gas. As the inert gas, argon, nitrogen and the like can be used.

Thereafter, the sintered body is subjected to surface grinding followed by blast treatment such as sandblast using SiC particles, thereby making through holes and bottomed holes in which temperature-measuring elements will be inserted. In this way, a ceramic substrate having, inside it, a chuck positive electrostatic layer and a chuck negative electrostatic layer is completed.

The resultant ceramic substrate is subjected to the same processes (2) to (5) as in the manufacturing method of the above-mentioned ceramic heater, thereby manufacturing an electrostatic chuck according to the present invention.

By embedding metal foil in the raw formed body in the shapes of the chuck positive electrostatic layer and the chuck negative electrostatic layer in the process (1) of the manufacturing method of the above-mentioned ceramic heater, an electrostatic chuck according to the present invention can be manufactured in the same way as the manufacturing method of the above-mentioned ceramic heater.

As a method for manufacturing a wafer prober according to the present invention, the same method for manufacturing the ceramic heater can be used except the following: in the manufacturing method of the above-mentioned electrostatic chuck, the same method of forming the chuck positive electrostatic layer and the chuck negative electrostatic layer inside the ceramic substrate is used to form guard electrodes and ground electrodes; blast treatment such as sandblast using SiC particles is conducted to form grooves and through holes; and subsequently sputtering and the like is used to form a chuck top conductor layer.

### Best Mode for Carrying Out the Invention

Hereinafter, the present invention will be described in more detail by means of Examples.

### (Example 1) Manufacture of a ceramic heater (see Figs. 1 and 2)

(1) A composition made of 100 parts by weight of aluminum nitride powder (average particle diameter: 0.6 µm), 4 parts by weight of yttria (average particle diameter: 0.4 µm), 12 parts by weight of an acrylic binder, and an alcohol was subjected to spray-drying to produce granular powder.
(2) Next, this granular powder was put into a mold and molded into a flat plate form, to obtain a raw formed body (green) .
(3) Next, this raw formed body was hot-pressed at 1800°C and a pressure of 20 MPa to yield an aluminum nitride plate having a thickness of about 3 mm.
   Next, a disc having a diameter of 210 mm was cut out from this plate to prepare a plate made of the ceramic (ceramic substrate 11). This ceramic substrate was drilled to form through holes 15, into which lifter pins 36 for a silicon wafer would be inserted, and bottomed holes 14 (diameter: 1.1 mm, and depth: 2 mm), in which thermocouples would be buried.
(4) A conductor containing paste layer was formed on the ceramic substrate 11 obtained in the above-mentioned (3) by screen printing. The printed pattern was a pattern as illustrated in Fig. 1.
   The above-mentioned conductor containing paste was a paste having a composition of Ag: 48% by weight, Pt: 21% by weight, SiO₂: 1.0% by weight, B₂O₃: 1.2% by weight, ZnO: 4.1% by weight, PbO: 3.4% by weight, ethyl acetate: 3.4% by weight, and butyl carbitol: 17.9% by weight.
   This conductor containing paste was aAg-Pt paste. Silver particles (Ag-540 made by Shoei Chemical Inc.) thereof had an average particle diameter of 4.5 µm, and were scaly. Pt particles (Pt-221 made by Shoei Chemical Inc.) thereof had an average particle diameter of 6.8 µm, and were spherical.
   The viscosity of the conductor containing paste at this time was 80 Pa•s.
(5) Furthermore, the ceramic substrate 11 was heated and fired at 850°C for 20 minutes after the formation of the conductor containing paste layer for a heating element pattern, so as to sinter Ag and Pt in the conductor containing paste and bake Ag and Pt onto the substrate 11. In this way, resistance heating elements 12 were formed.
(6) Next, portions to which external terminals 13 for ensuring connection to a power source would be fitted were subjected to Ni plating, and subsequently a silver-lead solder paste (made by Tanaka Kikinzoku Co.) was printed by screen printing, so as to form a solder layer.
   Next, the external terminals 13 made of Kovar were put on the solder layer, and heated and reflowed at 420°C to fit the external terminals 13 to the surface of the resistance heating elements 12.
(7) Thermocouples for controlling temperature were sealed with polyimide, to yield a ceramic heater 10.

### (Example 2) Manufacture of a ceramic heater

A ceramic heater was manufactured in the same way as in Example 1 except that as the conductor containing paste, a paste having the following composition was used and then heating and firing were performed to form resistance heating elements.

As the above-mentioned conductor containing paste, the following was used: a silver paste containing 7.5 parts by weight of metal oxides, relative to 100 parts by weight of silver, containing lead oxide: 5% by weight, zinc oxide: 55% by weight, silica: 10% by weight, boron oxide: 25% by weight and alumina: 5% by weight. Silver particles (Ag-540 made by Shoei Chemical Inc.) thereof had an average particle diameter of 4.5 µm, and were scaly.

The viscosity of the conductor containing paste at this time was 80 Pa•s.

Furthermore, after the formation of the conductor containingpaste layer for a heating element pattern, the ceramic substrate was heated and fired at 780°C for 20 minutes, so as to sinter silver and lead in the conductor containing paste and bake them onto the ceramic substrate.

### (Example 3) Manufacture of a ceramic heater

A ceramic heater was manufactured in the same way as in Example 1 except that after the heating and firing the conductor containing paste to form resistance heating elements, the resistance heating elements were subjected to sandblast treatment using alumina having an average particle diameter of 10 µm.

### (Example 4)

A ceramic heater was manufactured in the same way as in Example 1 except that Solvest PS603 made by Tokuriki Chemical Research Co., Ltd. was used as the conductor containing paste and fired at 780°C for 10 minutes to form resistance heating elements, and the resistance heating elements were subjected to sandblast treatment using alumina particles having an average particle diameter of 0.1 µm.

### (Example 5) Manufacture of a ceramic heater

A ceramic heater was manufactured in the same way as in Example 1 except that after the heating and firing the conductor containing paste to form resistance heating elements, the resistance heating elements were subjected to sandblast treatment using silicon carbide particles having an average particle diameter of 10 µm.

### (Example 6) Manufacture of a ceramic heater

A ceramic heater was manufactured in the same way as in Example 1 except that after the heating and firing the conductor containing paste to form resistance heating elements, the resistance heating elements were subjected to sandblast treatment using silicon carbide particles having an average particle diameter of 20 µm.

### (Example 7) Manufacture of a ceramic heater

A ceramic heater was manufactured in the same way as in Example 1 except that after the heating and firing the conductor containing paste to form resistance heating elements, the resistance heating elements were subjected to sandblast treatment using silicon carbide particles having an average particle diameter of 30 µm.

### (Examples 8 to 13)

A glass paste (G-5270 made by Shoei Chemical Inc.) was applied to the surface of each of the ceramic heaters manufactured in Examples 1 to 6, and subsequently the ceramic heater was fired at 600°C to form a glass coat on the surface.

### (Comparative Example 1) Manufacture of a ceramic heater

A ceramic heater was manufactured in the same way as in Example 1 except that the following paste was used as the conductor containing paste and the paste was heated and fired to form resistance heating elements.

The above-mentioned conductor containing paste was Solvest PS603 made by Tokuriki Chemical Research Co., Ltd. The viscosity of the conductor containing paste at this time was 80 Pa•s.

Furthermore, after the formation of the conductor containing paste layer for a heating element pattern, the ceramic substrate was heated and fired at 780°C for 10 minutes, so as to sinter silver in the conductor containing paste andbake silver onto the ceramic substrate.

Each of the ceramic substrates according to Examples 1 to 7 and Comparative Example 1 was put on a supporting case illustrated in Fig. 3. Thereafter, a semiconductor wafer was put thereon and an electric current was sent thereto so as to raise the temperature to 300°C. Next, the supply of the electric power was stopped and a cooling medium was supplied thereto so as to drop the temperature to 250°C. The ceramic substrate was evaluated by the following methods (1) and (2). As the cooling medium, air at a room temperature (20°C) was supplied at 0.1 m³/minute from a gas-introducing pipe fitted to the supporting case.

The ceramic heaters according to Examples 8 to 13 were evaluated by the following method (3).

The results are shown in Tables 1 and 2.

### Evaluation method

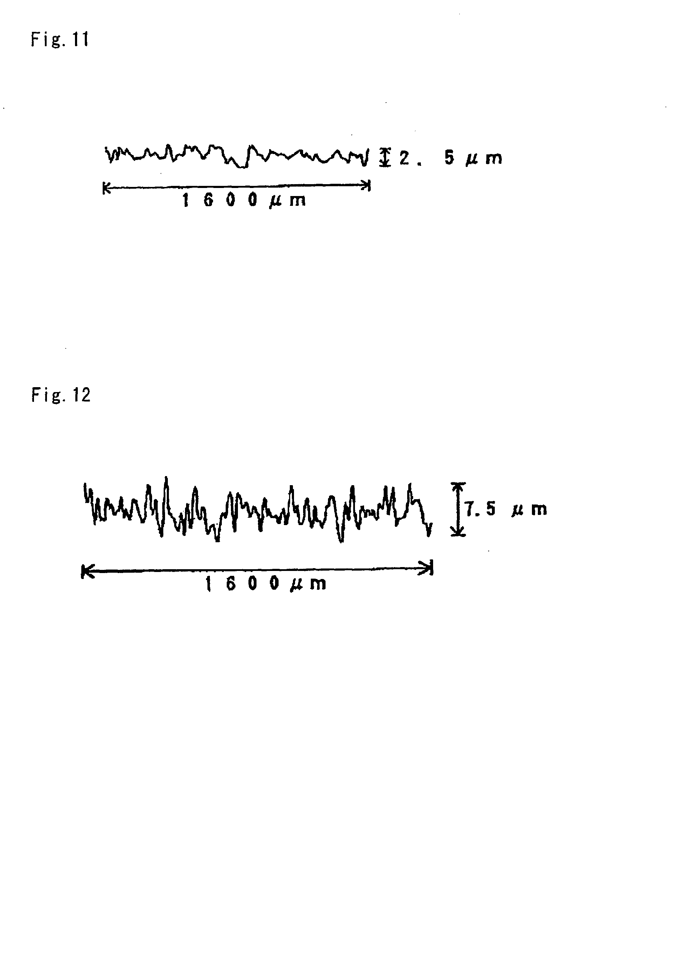

(1) Measurement of the surface roughness Ra of the conductor layer (resistance heating elements)
A surface roughness meter (Surfcom 920A, made by Tokyo Seimitsu Co.) was used to measure the surface roughness Ra of the surface of the resistance heating elements on the ceramic substrate formed in each of Examples and Comparative Example by a method according to JIS B 0601. The surface roughness Ra obtained from the measurement results are shown in Table 1. The surface roughness Ra obtained from the measurement results of Examples 1 and 2 are shown in Table 1. Charts showing the measurement results of Examples 1 and 2 are shown in Figs. 11 and 12, respectively.
(2) Measurement of temperature rising time and temperature dropping time
The following were measured: temperature rising time when the temperature was raised from room temperature to 300°C and temperature dropping time when the temperature was lowered from 300°C to 250°C.
The results are shown in Table 1.
(3) Heat cycle test
About each of the six ceramic heaters according to Examples 8 to 13, a heat cycle test within the range of 25°C to 500°C was repeatedly carried out 500 times to check whether a crack was generated or not. The results are shown in Table 2.

**Table 1**

| | Surface roughness Ra of the resistance heating elements (µm) | Temperature rising speed (second) | Temperature dropping speed (second) |
|---|---|---|---|
| Example 1 | 0.30 | 45 | 150 |
| Example 2 | 0.86 | 46 | 150 |
| Example 3 | 9.8 | 45 | 130 |
| Example 4 | 0.04 | 45 | 150 |
| Example 5 | 15.1 | 46 | 120 |
| Example 6 | 20.0 | 48 | 120 |
| Example 7 | 28.5 | 60 | 100 |
| Comparative Example 1 | 0.008 | 45 | 180 |

**Table 2**

| | Surface roughness Ra of the resistance heating elements (µm) | Crack |
|---|---|---|
| Example 8 | 0.30 | Not generated |
| Example 9 | 0.86 | Not generated |
| Example 10 | 9.8 | Not generated |
| Example 11 | 0.04 | Generated |
| Example 12 | 15.1 | Not generated |
| Example 13 | 20.0 | Generated |

As is evident from the results shown in Table 1, the ceramic heater according to Example 7, which had a surface roughness Ra of 28.5 µm, had the shortest temperature dropping time of 100 seconds. The ceramic heaters according to Examples 1 to 7 had a shorter temperature dropping time than the ceramic heater according to Comparative Example. This would be based on the following reason. Since in the ceramic heaters according to Examples the surface roughness Ra of the surface of their resistance heating elements was adjusted to 0.01 µm or more, the rough face formed on the surface of the resistance heating elements functioned as heat-radiating fins when the cooling medium was present around the resistance heating elements. Thus, the resistance heating elements were rapidly cooled so that the temperature of the ceramic substrates was able to drop rapidly.

The ceramic heaters according to Examples 6 and 7, which had a surface roughness Ra of 20 µm or more, had a long temperature rising time since they had a high heat-radiating effect.

On the other hand, the ceramic heater according to Comparative Example 1, which had a surface roughness Ra of 0.008 µm, had the temperature dropping time of 180 seconds. That is, it required a far longer time for temperature dropping than the ceramic heaters according to Examples. This would be based on the following reason. Since in the ceramic heater according to Comparative Example the surface roughness Ra of the surface of its resistance heating elements was less than 0.01 µm, the heat-radiating effect of the resistance heating elements deteriorated. As a result, rapid temperature dropping of the ceramic substrate was difficult.

A little difference in the temperature rising time, which appears to be caused by the difference in the surface roughness, was generated between the ceramic heaters according to Examples and Comparative Example. However, this difference is evidently smaller than the difference in the temperature dropping time. This wouldbe based on the following reason. When the temperature dropped, a temperature difference was very large between the supplied cooling medium and the resistance heating elements. Therefore, a great deal of heat was exchanged between the cooling medium and the resistance heating elements. On the other hand, when the temperature was raised, the temperature of the gas, which stayed inside the supporting case surrounding the resistance heating elements, followed the temperature of the resistance heating elements so that the temperature of the gas rose. As a result, a temperature difference became small between the resistance heating elements on a higher temperature side and the gas surrounding the resistance heating elements on a lower temperature side, so that heat was not exchanged very much between the two.

### Industrial Applicability

As described above, according to the ceramic heater of the present invention, the surface roughness Ra according to JIS B 0601 of resistance heating elements formed on the surface of the heater is 0.01 µm or more. Therefore, when a cooling medium was present around the heater, the rough face formed on the surface of the resistance heating elements functioned as heat-radiating fins. Thus, the resistance heating elements were rapidly cooled, and the temperature of the ceramic heater was able to drop rapidly.

## Claims

1. A ceramic heater for a semiconductor-producing/examining device comprising a resistance heating element on a surface thereof,
wherein
said resistance heating element has a surface roughness Ra according to JIS B 0601 of 0.01 µm or more.

2. The ceramic heater for a semiconductor-producing/examining device according to claim 1,
wherein
said surface roughness Ra according to JIS B 0601 of the resistance heating element is from 0.05 to 15 µm.

3. The ceramic heater for a semiconductor -producing/examining device according to claim 1 or 2,
wherein
an insulating covering layer is formed on said resistance heating element.
